**Europäisches Patentamt**

**European Patent Office**

**Office européen des brevets**

(19)

(11) Publication number : **0 492 680 B1**

# (12) EUROPEAN PATENT SPECIFICATION

(45) Date of publication of patent specification :
**19.07.95 Bulletin 95/29**

(51) Int. Cl.⁶ : **H03H 21/00, G10K 11/16**

(21) Application number : **91203005.3**

(22) Date of filing : **19.11.91**

(54) **Method and apparatus for attenuating noise.**

(30) Priority : **03.12.90 US 620801**

(43) Date of publication of application :
**01.07.92 Bulletin 92/27**

(45) Publication of the grant of the patent :
**19.07.95 Bulletin 95/29**

(84) Designated Contracting States :
**DE FR GB**

(56) References cited :
**GB-A- 2 069 280**
**US-A- 4 468 640**

(73) Proprietor : **GENERAL MOTORS
CORPORATION
General Motors Building
3044 West Grand Boulevard
Detroit Michigan 48202 (US)**

(72) Inventor : **Pfaff, Donald Paul
46900 Partridge Creek Drive
Mount Clemens, Michigan 48044 (US)**
Inventor : **Kapsokavathis, Nick S.
53440 Woodbridge Drive
Rochester, Michigan 48064 (US)**

(74) Representative : **Denton, Michael John et al
Patent Section
1st Floor
Gideon House
28 Chapel Street
Luton Bedfordshire LU1 2SE (GB)**

## Description

This invention relates to a method and apparatus for attenuating noise, particularly adapted to control output saturation.

Conventional active noise control systems attenuate undesirable noise, in the form of acoustic waves or mechanical vibrations, propagating from a noise source, by producing and superimposing noise cancelling waves or vibrations, which are substantially equal in amplitude and frequency content, but shifted 180 degrees in phase with respect to the noise. Recently, this has been achieved through the use of modern digital signal processing and adaptive filtering techniques. Typically, an input sensor, such as a microphone or accelerometer, is used to measure the noise generated by the source, and to develop a sampled input signal for a digital adaptive filter. This input is transformed by the adaptive filter into a sampled output signal, which is converted into analog form and sufficiently amplified for driving a speaker or actuator to produce cancelling acoustic waves or vibrations. An error sensor is employed to measure the observed residual noise level resulting from the superposition of the original noise and the cancelling waves or vibrations, and develops an associated error feedback signal. This feedback signal provides the basis for modifying the parameters of the adaptive filter to minimize the level of the observed residual noise.

The active filters used in noise control systems are commonly implemented by programming digital signal processors to function according to known algorithms. These signal processors have specified maximum output values associated with their output signals, above which the output signals become clipped and distorted. This undesirable condition, commonly referred to as filter output saturation, is normally avoided by providing a system actuator or speaker of adequate size, so that the associated driving analog signal can be sufficiently amplified to cancel the noise completely without causing the adaptive filter to exceed its specified maximum output value.

The above described active noise control systems have been applied to attenuate different forms of noise, such as acoustic and mechanical vibrations produced by the operation of an internal combustion engine. Because the amplitude of engine generated noise can become quite substantial, depending upon the rotational speed and loading conditions on the engine, the active noise control system must produce correspondingly large cancelling acoustic waves or vibrations to achieve complete noise cancellation. Usually this is not practical in engine noise applications, due to the constraints on the amount of electrical power available for amplification of the output cancelling waveform, and the physical size restrictions on the output actuator or speaker used for generating the cancelling vibrations or acoustic waves. For this reason, it is customary to adjust the output amplification such that the maximum output value specified for the adaptive filter corresponds to the maximum amplitude of the cancelling waveform that can be applied to the system output actuator or speaker.

Consequently, when an engine generates noise at levels greater than the maximum amplitude associated with the cancelling waveform, the adaptive filter will attempt to increase the value of its output signal, to minimize the observed residual noise. In doing so, the maximum output value specified for the filter will be exceeded, and filter output saturation will occur. This results in a distorted cancelling waveform, which actually contributes to the residual noise level, and prevents complete noise cancellation. In addition, the clipped portions of the output cancelling waveform result in large constant amplitude levels, which can damage a noise cancellation actuator, such as an audio speaker.

Consequently, there exists a need for a method of controlling output saturation in adaptive filters used in active engine noise control systems.

The present invention seeks to provide an improved method and apparatus for attenuating noise.

According to an aspect of the present invention, there is provided a method of attenuating noise as specified in claim 1.

This aspect can ensure that the distortion associated with the clipping of the adaptive filter output signal is avoided, as well as the possibility of damaging the output actuator or speaker used by the active noise control system.

Preferably, an average power associated with the filter output signal is computed and a power reference level is derived to estimate the maximum average power that the output signal can contain without causing filter output saturation. Based upon the difference between the power reference level and the computed average power, the adaptation of filter weighting coefficients is adjusted to reduce the filter output signal value when the average power exceeds the power reference level. This may be realized by modifying existing software associated with an adaptive filter, without requiring any additional hardware in an active noise control system.

In the preferred embodiment of the present invention, a least mean squares algorithm is used for filter adaptation. Based upon this algorithm, the filter weighting coefficients are adapted as a function of the values for a leakage coefficient term and an error signal associated with the residual noise level. By appropriately adjusting the value for the leakage coefficient and error signal during filter adaptation, it has been recognized that the value of the filter output signal can be reduced, without introducing any significant distortion. The embodiment takes advantage of this feature and scales the leakage coefficient term and error signal, as a function of the difference between the derived power reference level and the computed average power associated with the filter output signal. As a result, the amplitude values of the adaptive filter output signal are reduced without adding significant distortion, when a saturation condition is detected.

In addition, the present invention can be generally applicable to the control of output saturation in any adaptive filter that modifies its weighting coefficients as a function of a leakage coefficient term and an error signal term.

According to another aspect of the present invention, there is provided apparatus for attenuating noise as specified in claim 5.

Due to its nature, the present invention may be implemented by modifying the existing software associated with an adaptive filtering algorithm, without requiring any additional system hardware. The particulars of this method of output saturation control are described below, in terms of flow diagrams representative of the software modification programmed into an electronic noise controller.

An embodiment of the present invention is described below, by way of illustration only, with reference to the accompanying drawings, in which:

Figure 1 is a schematic diagram of an embodiment of active noise control system used to attenuate engine generated noise;

Figure 2 is a schematic model for a Filtered X Least Mean Squares (LMS) adaptive filter utilized in the active noise control system illustrated in Figure 1;

Figure 3 is a schematic diagram representative of an off-line calibration process for an auxiliary filter used in the adaptive filter illustrated in Figure 2;

Figures 4a and b are a flow diagram representative of the instructions in an embodiment of routine executed by the noise control system of Figure 1, for adapting the weighting coefficients of the digital filter shown in Figure 2;

Figure 5 graphically illustrates time variations in the voltage, average power, and a power reference level associated with the output signal of the adaptive filter illustrated in Figure 2; and

Figures 6a and b are a flow diagram representative of the instructions in a subroutine of the routine of Figure 4a, which establishes a power reference level.

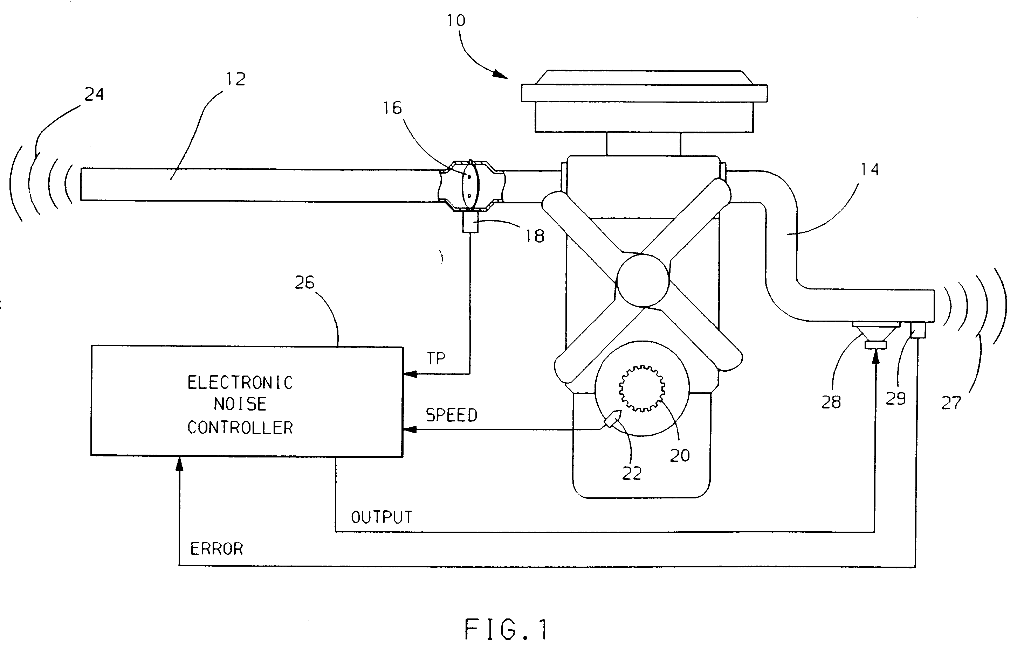

Referring to Figure 1, there is shown schematically an internal combustion engine 10 with its associated air intake system 12 and exhaust system 14. A rotatable throttle valve 16 is included within the air intake system 12 for regulating air flow to the engine 10. Also shown are two sensors generally associated with the electronic control of engine performance. The first is a standard throttle position sensor 18, such as a potentiometer, which is connected to throttle valve 16 and develops an electrical signal TP related to the degree or percent of throttle valve opening. The second is a conventional engine rotational sensor, which includes a toothed wheel 20 mounted on the engine crankshaft and an electromagnetic sensor 22 that produces a SPEED signal having pulses corresponding to the movement of teeth on wheel 20 past electromagnetic sensor 22.

During the operation of engine 10, acoustic pressure waves are generated which propagate away from the engine through the ducts and tubes forming the air intake and exhaust systems. Eventually, these pressure waves propagate from openings in the intake and exhaust systems as observable engine induction noise 24 and exhaust noise 27. The engine also generates other forms of noise that are not shown in Figure 1, such as mechanical vibrations which are transferred to the mounting structure used in supporting the engine.

Figure 1 illustrates an active noise control system provided to reduce exhaust noise 27 generated by engine 10. As described more fully in European Patent Application No. 91202477.5, the engine SPEED signal is directed to electronic noise controller 26, where it is processed to derive an INPUT signal indicative of the harmonic frequency content in the exhaust noise produced by engine 10. The INPUT signal may be derived from the engine SPEED signal using any other technique known in the art, or alternatively, it could result from a direct measurement of noise in the exhaust system 14, using an acoustic microphone placed upstream from speaker 28. As further described in European Patent Application No. 91201872.8, the amplitude of the derived INPUT signal may be adjusted on the basis of the throttle position signal TP to improve the response of the active noise control system to abrupt changes in engine loading. Based upon this adjusted INPUT signal, the noise controller 26 produces an out-of-phase cancelling signal designated as OUTPUT. This OUTPUT signal drives cancellation speaker 28, or any other type of actuator capable of generating the cancelling waves that are superimposed with the exhaust noise propagating within the exhaust system 14. Typically, an error microphone 29, or other suitable sensor, is employed to measure the level of the attenuated noise remaining after the superposition of the cancelling acoustic waves and to develop a corresponding analog ERROR feedback signal. This ERROR signal is directed to electronic noise controller 26, and provides the basis for minimizing the observed residual exhaust noise 27 propagating out of engine 10.

The electronic noise controller 26 preferably includes a standard digital signal processor with necessary interfacing circuitry such as analog amplifiers and filters, analog-to-digital and digital-to-analog converters, frequency multipliers, counters, clocks, and other known input/output signal conditioning circuitry. Digital signal processors are commercially available, for example the Motorola 56000, and typically contain a central processing unit for carrying out instructions and arithmetic operations, random access memory for storing data, and read only memory for permanently storing program instructions. When used for active noise control, the digital signal processor is typically programmed to function as an adaptive filter, as subsequently will be described.

The amplitudes of the various analog signals directed to noise controller 26 are repeatedly sampled at a fixed sampling rate, and sets of these signals are retained in memory for use in generating corresponding sample values for the OUTPUT signal. In the following description, the most recently generated sample values for the INPUT and ERROR signals will be denoted as INPUT(n) and ERROR(n), with INPUT(n-N+1) representing the oldest value in the sequence of N samples of the INPUT signal that is retained in memory. These retained sample values are utilized by the adaptive filtering algorithm programmed into noise controller 26 to generate an OUTPUT(n) signal value, representing the most recently generated value in a sequence of N retained samples, which corresponds to the voltage of the analog OUTPUT signal. Electronic noise controller 26 converts the sequence of OUTPUT(n) sample values into an analog waveform, which is then appropriately amplified to form the analog OUTPUT signal, used for driving speaker 28, as illustrated in Figure 1.

The actual hardware implementation of noise controller 26 is not described herein, since such circuitry is well known in the art and is described in numerous publications and text books, see for example, "Hardware and Software Considerations for Active Noise Control", M. C. Allie, C. D. Bremigan, L. J. Eriksson, and R. A. Grainier, 1988, IEEE, CH 2561-9/88/000-2598, pp. 2598-2601.

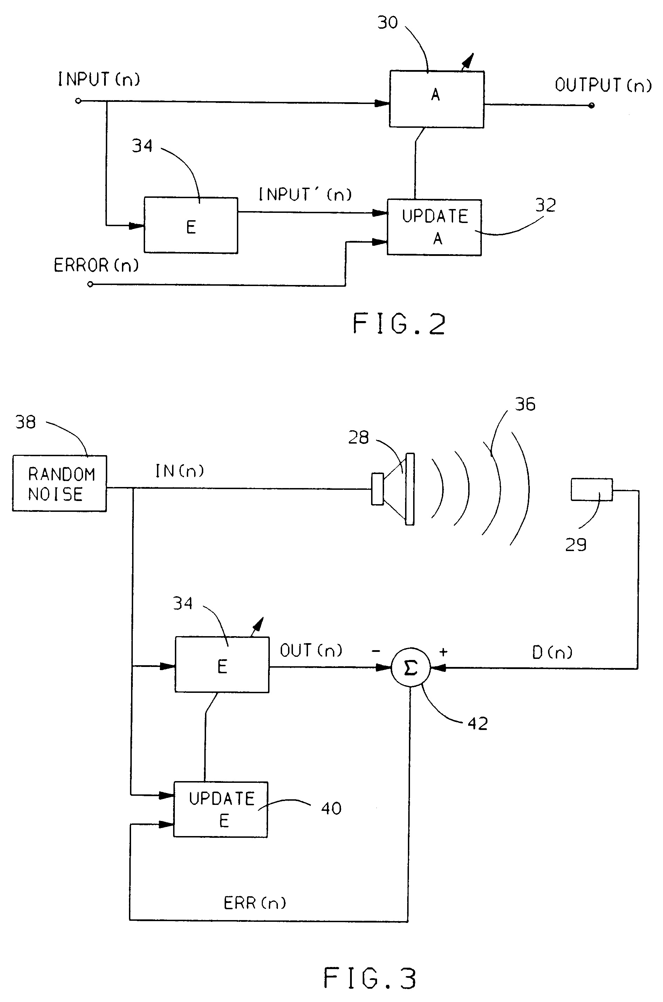

Referring now to Figure 2, there is shown schematically, a Filtered X Least Mean Squares (LMS) adaptive filter, which is the type of non-recursive filtering algorithm preferably programmed into the active noise control system for the particular application illustrated of Figure 1. Only a brief explanation of the operation of this particular type of adaptive filter will be provided here, as a detailed description can be found in the text book Adaptive Signal Processing, B. Widrow and S. Sterns, Englewood Cliffs, New Jersey, Prentice-Hall, Inc., 1985, pp. 288-294.

Consecutive OUTPUT(n) sample values are produced at the system sampling rate by adaptively filtering the most recent INPUT(n) sample value and the other N-1 retained samples in the INPUT sequence, using the non-recursive digital A filter 30. New sample values for OUTPUT(n) signal are computed on the basis of the following algorithm:

$$OUTPUT(n) = \sum_{i=0}^{N-1} A_i(n) * INPUT(n-i), \qquad (1)$$

where the set of $A_i(n)$ represents the most recently computed adaptive filter weighting coefficients for the A filter, and N represents the size of the filter as well as the number of samples of generated input signal retained in memory. Prior to storing each newly computed value for OUTPUT(n), the previous value is shifted and stored as OUTPUT(n-1), and so forth down to the oldest sample OUTPUT(n-N+1) retained in the sequence.

After a new sample value for OUTPUT(n) signal is computed, the adaptive filter coefficients $A_i(n)$ are updated as indicated by the UPDATE A block 32 in the diagram, in order to minimize the ERROR(n) sample value representative of the residual engine noise remaining after the superposition of the cancelling noise waveform. The UPDATE A block 32 has two inputs, the first being ERROR(n), and the second being a filtered sequence of sample values designated as INPUT'(n) derived by passing the corresponding sequence of input signal samples INPUT(n) through a fixed auxiliary E filter 34. The algorithm for updating or adapting each of the filter weights $A_i(n)$ to $A_i(n+1)$, for the next sampling interval is given by:

$$A_i(n + 1) = g * A_i(n) - u * ERROR(n) * INPUT'(n - i), \quad (2)$$

where g represents the filter leakage coefficient, generally having a value in the range of $0 \ll g < 1$, and u represents the filter convergence factor, generally having a constant value in the range of $0 < u \ll 1$. The convergence factor u is related to rate at which the actual filter output converges to approach a desired output signal. The leakage coefficient g reduces digital quantization and round off errors, when given a value slightly less than one and, thus, improves the stability of the filter. Conventionally, the values for g and u are held con-

EP 0 492 680 B1

stant, at for example g = 0.999 and u = 0.03.

The sequence of sample values for the INPUT'(n) signal in equation (2) are obtained by filtering the sequence of INPUT(n) values with the fixed auxiliary E filter 34 according to the following equation:

$$\text{INPUT}'(n) \;=\; \sum_{i=0}^{N-1} E(i) \;*\; \text{INPUT}(n-i), \qquad\qquad (3)$$

where the E(i) represent the fixed weighting coefficients for the auxiliary E filter. As described in "An Analysis of Multiple Correlation Cancellation Loops with a Filter in the Auxiliary Path", D. R. Morgan, IEEE Transactions on Acoustic Speech Signal Processing, Vol. ASSP-28, No. 4, 1980, pp.454-467, the auxiliary E filter 34 is used to compensate for the distortion produced by components in the error path of the active noise control system. This error path typically includes the cancellation actuator (such as speaker 28) and the associated output circuitry within noise controller 26; the error sensor 29 and the associated error input circuitry within noise controller 26; and the characteristics of the physical path, including the propagation delay time, between the cancellation actuator 28 and error sensor 29, over which the engine noise propagates.

Referring now to Figure 3, there is shown a schematic diagram representing the process used for calibrating auxiliary E filter 34, to obtain the appropriate fixed weighting coefficients E(i). When calibrating the E filter 34 to have a transfer function equivalent to the combined components in the error path, the cancellation actuator 28, the noise propagation path 36, and the error sensor 29 remain in the same physical locations as when used for cancelling engine exhaust noise, as shown in Figure 1.

The calibration process uses a conventional RANDOM NOISE SOURCE 38 to generate a sequence of random signal values designated as IN(n). The random signal samples are directed as input to the auxiliary E filter 34, and are also passed through the components of the error path to produce a corresponding sequence of samples designated as D(n). In passing over the error path, the IN(n) samples are subjected to the same components as are the OUTPUT(n) samples and the resulting ERROR(n) samples of Figure 2.

For the calibration system shown in Figure 3, the algorithms associated with the auxiliary E filter 34, and its adaptation by the UPDATE E block 40, are given by:

$$\text{OUT}(n) \;=\; \sum_{i=0}^{N-1} E_i(n) \;*\; \text{IN}(n-i), \text{ and} \qquad (4)$$

$$E_i(n + 1) \;=\; g * E_i(n) + u * \text{ERR}(n) * \text{IN}(n - i), \quad (5)$$

where, $E_i(n)$ represents the variable weighting coefficients for the auxiliary E filter 34, the OUT(n) samples represent values of the filter output, and the ERR(n) samples are produced as output from summer 42 and are given by:

$$\text{ERR}(n) \;=\; D(n) - \text{OUT}(n), \quad (6)$$

where D(n) represents the sample values derived from the error sensor 29. With this off-line calibration process, the weighting coefficients $E_i(n)$ of the auxiliary E filter 34 are adaptively updated to minimize the ERR(n) values. The adaptive modelling procedure is complete when the variable weighting coefficients $E_i(n)$ sufficiently converge to fixed values, which then correspond to the fixed weighting coefficients E(i) of the E filter 34. When the modelling procedure is complete, the fixed transfer function of the auxiliary E filter 34 duplicates that of the combined components in the channel error path, and is used as illustrated in Figure 2 to compensate for the distortion and propagation time delay introduced by components in the system error path.

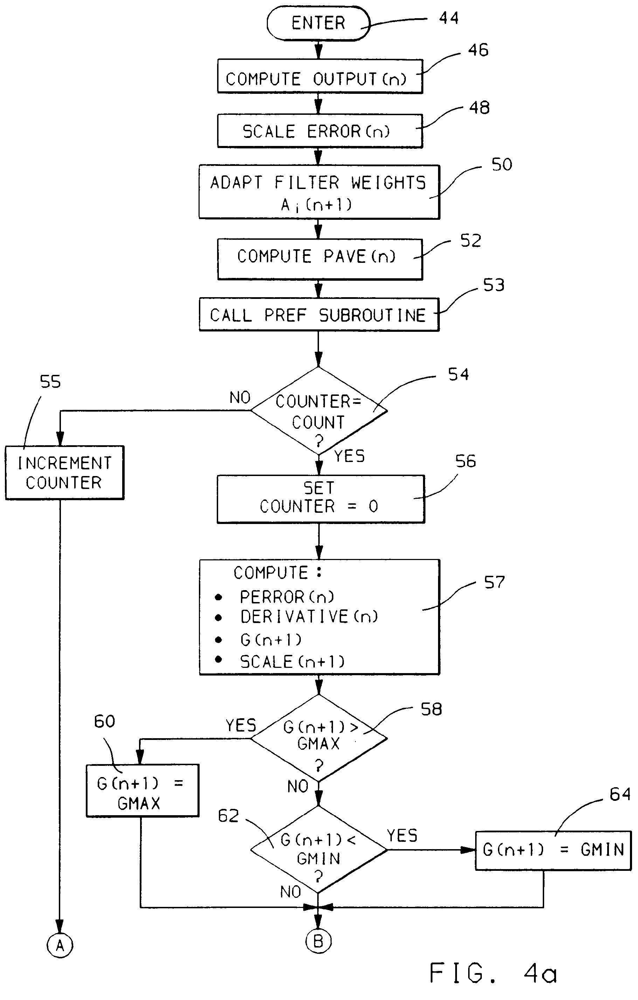

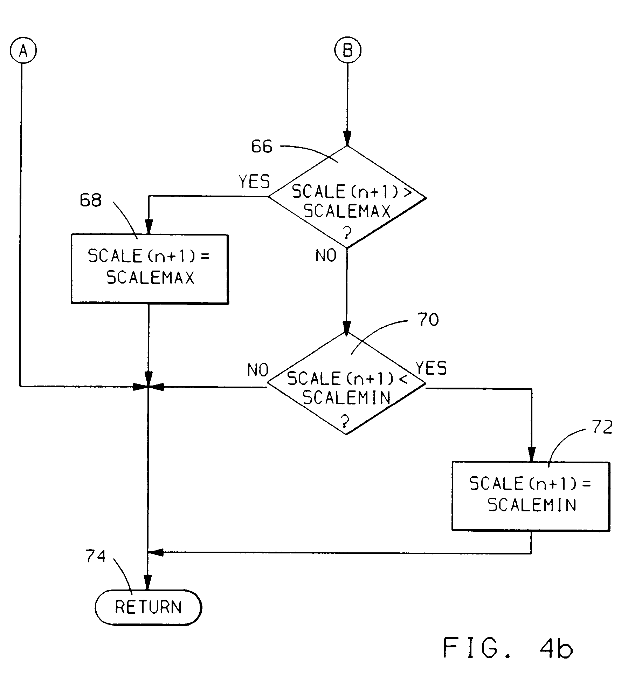

The routine illustrated by the flow diagram in Figure 4 is part of a background loop that is repeatedly executed after each system interrupt associated with the sampling rate of the electronic noise controller 26. The routine, in effect, adjusts the above-described equations so as to control the output of the filter 30.

Prior to entering this background loop for the first time, all of the appropriate system counters, flags, and variables are appropriately initialized.

After the routine of Figure 4 is entered at point 44, it proceeds to step 46, where a new value for the filter output sample OUTPUT(n) is computed on the basis of equation (1) above. Prior to storing this new sample value as OUTPUT(n), the previous value for OUTPUT(n) is shifted to OUTPUT(n-1), and likewise for all of the filter output samples stored in memory, down to the last retained sample OUTPUT(n-N+1).

5

Next, the routine proceeds to step 48, where a new adjusted value for the ERROR(n) sample is obtained by multiplying its value prior to adjustment, represented by $ERROR(n)_{-1}$, by a scaling factor designated as SCALE(n), thus:

$$ERROR(n) = ERROR(n)_{-1} * SCALE(n), \quad (7)$$

where SCALE(n) is initialized to a value of for example 1.0, prior to the first pass through the routine, but is thereafter modified, as described at later steps 57, and 66 through 72, each time the routine is executed.

At the next step 50, the current set of filter weighting coefficients $A_i(n)$ are adapted or updated to $A_i(n+1)$, according to the equation:

$$A_i(n + 1) = G(n) * A_i(n) - u * ERROR(n) * INPUT'(n - i), \quad (8)$$

which is basically equivalent to the conventional filter adaptation equation (2), except that the new adjusted value for ERROR(n) from step 48 is used, and the conventional constant leakage coefficient g is replaced with a variable leakage coefficient G(n).

Prior to the first pass through the routine, G(n) is initialized to an appropriate value, for example 0.999, but thereafter, its value is modified, as described at later steps 57 through 64, each time the routine is executed. The significance of these modifications to the conventional filter adaptation equation is more fully explained below.

The routine then proceeds to step 52, where a representation for the average power in the stored sequence of filter OUTPUT(n) signal values is computed using the following equation:

$$PAVE(n) = (1/N) \sum_{i=0}^{N-1} [OUTPUT(n-i)]^2, \quad (9)$$

where each output sample value is assumed to represent a voltage amplitude sample, and the power in each output sample is then given by the square of its voltage value. The average power is normalized by assuming that the voltage associated with each output value appears across a one ohm resistor.

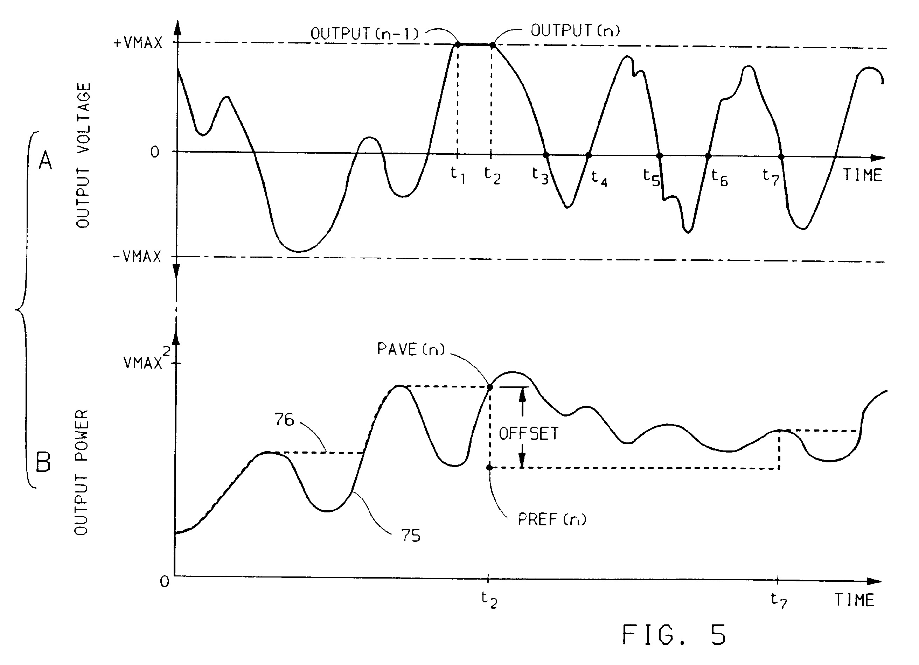

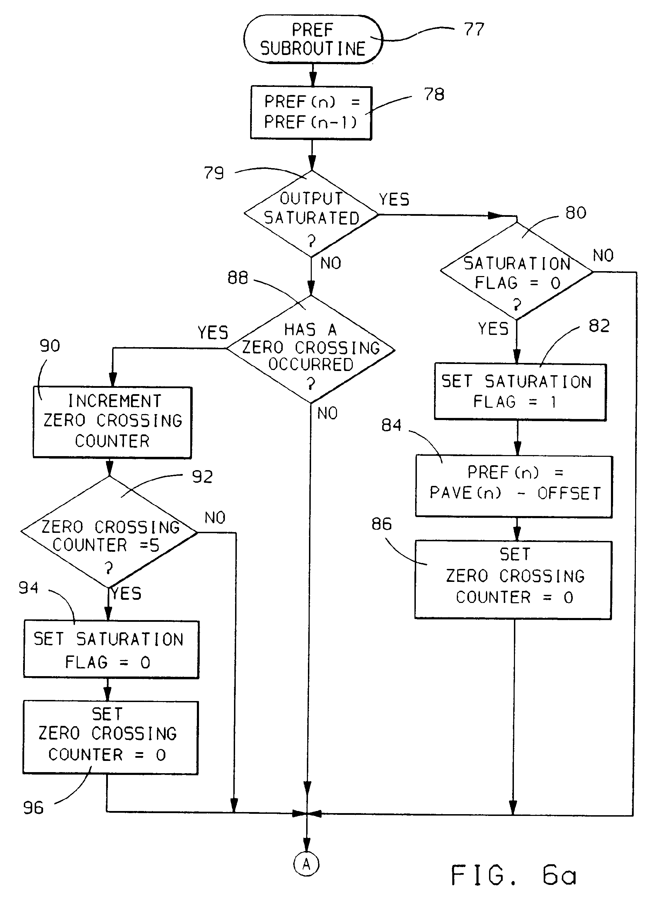

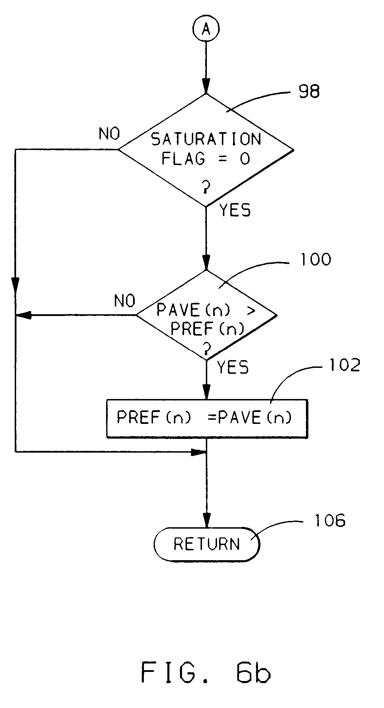

At the next step 53, a PREF subroutine is called. This subroutine computes and returns a value for a power reference level PREF(n), which represents the current estimate for the maximum permissible average power that can be associated with the filter output signal without causing filter output saturation. The procedure for obtaining PREF(n), and the steps in the subroutine are described below in conjunction with Figures 5 and 6.

Next at step 54, the value of a COUNTER is examined to determine whether it equals COUNT. Prior to entering the routine for the first time, COUNTER will have been initialized to zero. If COUNTER does not equal COUNT, the routine proceeds to step 55, where the COUNTER is incremented by one and the routine is then exited at step 74. If COUNTER is equal to COUNT, the routine proceeds to step 56, where COUNTER is then reset to zero, before proceeding to step 57. Thus, the remainder of the routine starting at step 57, which deals with adjustments to filter adaptation, is executed only after the COUNTER has been incremented to equal COUNT. The purpose of steps 54 through 56 is to assure that a sufficient time has elapsed between any changes that are made in the filter adaptation process. In the preferred embodiment, a COUNT of 9 has been found to be sufficient, i.e. the steps starting at 57 are only executed every tenth time through the routine.

When the routine proceeds to step 57, a series of computations are completed to update the value for the SCALE(n) variable used at step 48, and to assign a different value to the new filter leakage coefficient G(n). First, an error variable, PERROR(n), is computed as the difference between the current power reference level and the average power in the filter output, according to:

$$PERROR(n) = PREF(n) - PAVE(n). \quad (10)$$

Next, a value for the variable DERIVATIVE(n), which represents the time rate of change of PERROR(n), is computed based upon the equation:

$$DERIVATIVE(n) = PERROR(n) - PERROR(n - 1). \quad (11)$$

These values for PERROR(n) and DERIVATIVE(n) are then used to compute new values for the SCALE(n) factor and filter leakage coefficient G(n), which will be used during the next pass through the routine at steps 48 and 50. The new values G(n+1) and SCALE(n+1) are obtained from the equations:

$$G(n + 1) = G(n) + PERROR(n) * KP + DERIVATIVE(n) * KD, \quad (12)$$

and

$$SCALE(n + 1) = SCALE(n) + PERROR(n) * KP + DERIVATIVE(n) * KD. \quad (13)$$

Those skilled in the art will recognize that equations (12) and (13) take the standard form of a proportional integral derivative control scheme, in which the integral feedback term is absent. In the preferred embodiment of the present invention, satisfactory performance has been achieved by setting constants KP = 0.0005 and KD = 0.0005. Thus, the new values for G(n+1) and SCALE(n+1) given by equations (12) and (13) are based upon the value of PERROR(n) and the rate of change in PERROR(n), where PERROR(n) represents the difference between the power reference level PREF(n) and the average power associated with the filter output PAVE(n).

When the average power in the filter output signal exceeds the power reference level, the values of SCALE(n+1) and G(n+1) are reduced on the basis of equations (12) and (13). On the next pass through the routine, the filter weighting coefficients will be adjusted using these new reduced values for G(n) and SCALE(n) at steps 48 and 50. Accordingly, the value of the filter output signal will then be scaled down, so that output saturation does not occur. When the average power associated with the filter output signal does not exceed the power reference level, the values of SCALE(n+1) and G(n+1) can be increased to accommodate adaptive increases in the filter output, since output saturation is not presently occurring.

In adjusting filter adaptation through the use of equations (12) and (13), it has experimentally been found, that the adaptive filter used in the preferred embodiment functions best if G(n+1) and SCALE(n+1) are restricted to specific ranges of values. In the remaining steps 58 through 72 of the routine, the values of G(n+1) and SCALE(n+1) are limited to specified maximum and minimum values.

At step 58, a decision is made as to whether the value of G(n+1) computed at step 57 is larger than a maximum permissible value GMAX. If G(n+1) is not greater than GMAX, the routine proceeds to step 62. If G(n+1) is greater than GMAX, the routine proceeds first to step 60, where G(n+1) is assigned the value of GMAX, and thereafter passes to step 66.

At step 62, a decision is made as to whether G(n+1) is less than a minimum permissible value GMIN. If G(n+1) is not less than GMIN, the routine proceeds directly to step 66. However, if G(n+1) is less than GMIN, the routine proceeds first to step 64, where G(n+1) is assigned the minimum value GMIN, and then proceeds to step 66. For the adaptive filter used in the preferred embodiment of the present invention, the best filter performance and saturation control was achieved when the GMIN and GMAX were given the approximate values of GMIN = 0.992 and GMAX = 0.999.

At step 66, a decision is made as to whether the value of SCALE(n+1) computed at step 57 is above a maximum permissible value SCALEMAX. If SCALE(n+1) is not greater than SCALEMAX, the routine proceeds directly to step 70. However, if SCALE(n+1) is greater than SCALEMAX, the routine proceeds first to step 68, where SCALE(n+1) is assigned the maximum value of SCALEMAX, and thereafter passes to step 74.

At step 70, a decision is made as to whether SCALE(n+1) is less than a minimum permissible value SCALEMIN. If SCALE is not less than SCALEMIN, the routine proceeds directly to step 74. If SCALE(n+1) is less than SCALEMIN, the routine proceeds first to step 72, where SCALE(n+1) is assigned the minimum value SCALEMIN, and then proceeds to step 74. In the preferred embodiment of the present invention, the approximate values of SCALEMIN = 0.001 and SCALEMAX = 1.0 were found to provide the best adaptive filter performance and control of output saturation.

At point 74, the routine is exited, and the remainder of the background loop programmed into electronic noise controller is completed. After the next system sampling interrupt, the routine is again entered at point 44 to compute the next sample value for the filter OUTPUT(n) signal.

In the above routine, a PREF subroutine was called at step 53, and it returned a value for the power reference level PREF(n). This power reference level represents an estimate of the maximum value for the average power in the filter output signal, that is known not to cause output saturation. Ideally, PREF(n) should be as large as possible, without permitting the filter output to saturate. The method for obtaining a value for PREF(n) is most easily described in terms of the representative voltage and power plots versus time that are presented in Figure 5.

Figure 5(A) shows a continuous time representation for the filter OUTPUT(n) samples values, which are assumed to represent voltage samples. The maximum specified output value for the filter is shown as VMAX. The filter output is considered to be saturated whenever the magnitudes of two consecutive OUTPUT(n) samples are equal VMAX. Thus, filter output saturation occurs at the indicated time $t_2$, since the magnitudes of both OUTPUT(n) and the previous sample OUTPUT(n-1) are both equal to the specified maximum output value VMAX.

As shown in Figure 5(B), solid curve 75 provides a continuous time representation of the average power associated with the filter output samples, while dotted curve 76 gives a continuous time representation of the power reference level samples, determined on the basis of the above equations. Prior to filter output saturation at time $t_2$, the power reference level curve 76 assumes the maximum value attained by the average power curve 75. In this way, the power reference level tends to increase to its maximum permissible level. The detection of output saturation, at time $t_2$, indicates that the power reference level has become too large. Thus, at time $t_2$, the power reference level PREF(n) is decreased as shown in Figure 5(B), to the current value of the average output power PAVE(n), reduced by a predetermined OFFSET amount. Once this occurs, the average power associated with the filter output exceeds the new power reference level and the adaptation of the filter weighting coefficients will be controlled accordingly, to eliminate output saturation.

Once the power reference level has been decreased due to the detection of filter output saturation, it is not allowed to begin assuming the maximum value attained by the average power for a period of time that is sufficient to assure that the saturation condition has ended. In the preferred embodiment of the present invention, this waiting period is established by counting the number of times the value of the filter output signal traverses zero, without any intervening saturation conditions. A zero crossing is considered to have occurred whenever the product of the values for a new output sample and the immediately preceding output sample is less than or equal to zero. It has been found that the time required for the occurrence of at least five such zero crossings is generally sufficient, in the preferred embodiment, to assure that the modified filter adaptation process has scaled down the filter output signal to eliminate the saturation condition, although a different number of zero crossings may perform equally well in other embodiments. Thus, after five zero crossings, at time $t_7$, the output saturation condition is considered to have ended, and the value for the power reference level can assume the maximum value attained by the average power associated with the filter output signal.

Referring now to Figure 6, there is shown a flow diagram representing the steps within the subroutine PREF, that are executed to obtain a value for the power reference level, as described above. The PREF SUBROUTINE is entered at point 77, and proceeds to step 78.

At step 78, the PREF(n) is initially set equal to PREF(n-1), the value it had during the previous pass through the subroutine. Prior to entering the subroutine for the first time, PREF(n) will have been initialized to a value of, for example, 0.5.

Next at step 79, a decision is required as to whether a filter output saturation condition exists. This is determined by monitoring the value of the most recent filter OUTPUT(n) sample and the previous filter OUTPUT(n-1) sample. If both OUTPUT(n) and OUTPUT(n-1) have magnitudes equal to the specified maximum output signal value for the adaptive filter, denoted in Figure 5(A) by VMAX, then it is assumed that the filter output has been clipped to this maximum level and a saturation condition exists. If a saturation condition is detected, the subroutine proceeds from step 79, to the next decision step 80. If the filter output is not saturated, the subroutine proceeds to decision step 88.

Assuming that a saturation condition was detected at step 79, the subroutine will proceed to step 80. At step 80 a decision is required as to whether the saturation FLAG = 0. When FLAG = 1, the detected saturation condition at step 79 will be a continuation of the same saturation condition detected on an earlier pass through the PREF SUBROUTINE, and the program will proceed to step 98. However, if FLAG = 0, this indicates that the saturation condition has just occurred and the routine will pass to step 82.

At step 82, the saturation FLAG will be set to 1, indicating that a new saturation condition has just been detected.

Next at step 84, the power reference level is set equal to the current average power associated with the filter output reduced by a predetermined amount, according to:

$$PREF(n) = PAVE(n) - OFFSET. \quad (14)$$

In the preferred embodiment of the present invention, the specified maximum output value for the adaptive filter was VMAX = 1.0, and in this situation, satisfactory performance was achieved by setting OFFSET = 0.1 * VMAX = 0.1.

Then at step 86, a ZERO CROSSING COUNTER is set equal to 0, indicating that for the new saturation condition, the value of the output signal has not yet crossed zero. The routine then proceeds to step 98.

Returning again to the decision made at step 79, if an output saturation condition was not detected, the routine will have passed to step 88. At step 88, a decision is required as to whether a zero crossing has occurred between the most recent OUTPUT(n) sample value and the previous OUTPUT(n-1) sample value. A zero crossing is considered to have occurred when the product of OUTPUT(n)*OUTPUT(n-1) is less than or equal to zero. If this product is positive, a zero crossing is considered not to have occurred and the routine proceeds to step 98. If a zero crossing has occurred, the routine passes to step 90.

At step 90, the current count of the ZERO CROSSING COUNTER in incremented by 1, to account for the zero crossing detected at step 88.

Next at step 92, a decision is required as to whether ZERO CROSSING COUNTER = 5, indicating that 5 zero crossing have occurred. If the count is equal to 5, the routine proceeds to step 94. If the count of ZERO CROSSING COUNTER is not equal to 5, the routine passes to step 98.

At step 94, the saturation FLAG is set to 0, indicating 5 zero crossing have occurred, and a sufficient time has passed to consider the saturation condition ended.

Then at step 96, the ZERO CROSSING COUNTER is reset to 0, before the routine proceeds to step 98.

Now at step 98 (Figure 6b), a decision is required as to whether the saturation FLAG = 0. If FLAG is not equal to 0, the routine passes to step 106. If FLAG = 0, the routine proceeds to step 100.

At step 100, a decision is required as to whether the average power associated with the filter output PAVE(n) is greater than the present value for PREF(n). If PAVE(n) is not greater that PREF(n), the subroutine proceeds to step 106. However, if PAVE(n) is greater than PREF(n), the subroutine proceeds to step 102.

At step 102, PREF(n) is set equal to PAVE(n), since the PREF(n) is allowed to assume the maximum value attained by PAVE(n), as long as output saturation is not detected. After this step, the subroutine passes to step 106, where it returns a value for PREF(n) to the routine where it was called, and then proceeds to the next step in that routine, which in this case is step 54 in the routine of Figure 4.

Although a Filtered X Least Mean Squares (LMS) adaptive filter has been described above as the preferred type of non-recursive adaptive filter for the preferred embodiment, it will be understood that any other adaptive filter can be used which has its weighting coefficients adjusted on the basis of an error signal and a term commonly referred to as a leakage coefficient. Those acquainted with the adaptive filter art will recognize that two different sets of weighting coefficients require adapting or updating in a recursive type adaptive filter. As long as the equations for adapting both sets of weighting coefficients contain leakage coefficient and error signal terms, the second set of weighting coefficients can be adapted in the same fashion as the first set, as described at step 50 in the routine shown in Figure 4. Thus, the embodiment can be easily adapted to use a recursive type adaptive filter, which is typically used in the type of active noise control systems that derive their input signals by directly measuring the noise to be cancelled, with an input sensor or microphone.

It will also be recognized by those skilled in the art that the described embodiment may also be applied to cancel other forms of noise, such as mechanical vibrations or the acoustic induction noise generated by an internal combustion engine, see for example, European Patent Application No. 91202477.5.

## Claims

1. A method of attenuating noise by means of apparatus including an adjustable filter, which filter has a maximum filter output value above which filter saturation occurs and adjustable filter weighting coefficients; the method comprising the steps of deriving input values representative of noise to be attenuated; filtering the input values to produce filter output values based upon the adjustable filter weighting coefficients; generating a noise cancelling waveform from the filter output values and superimposing the noise cancelling waveform on the noise; sensing residual noise after superposition of the noise cancelling waveform on the noise the developing error values representative of the residual noise; adjusting the filter weighting coefficients on the basis of the error values so as to reduce the residual noise; characterized by monitoring the filter output values to detect the occurrence of filter saturation; modifying the filter weighting coefficients to decrease filter output values in response to the detection of filter saturation.

2. A method according to claim 1, wherein the step of monitoring the filter output values comprises the steps of obtaining an average power value based upon filter output values; deriving a power reference level representative of an estimate of an upper limit for the average power value above which filter saturation occurs; and, when the average power value exceeds the power reference level, modifying the filter weighting coefficients to decrease the filter output values on the basis of the difference between the power reference level and the average power value.

3. A method according to claim 2, wherein the step of deriving the power reference level includes the steps of monitoring the filter output values to detect whether the maximum output value of the filter has been reached or exceeded; when the maximum filter output value has not been reached or exceeded and the average power value is greater than the power reference level, setting the power reference level to equal the average power value; and when the maximum filter output value has been reached or exceeded, setting the power reference level equal to the average power value reduced by a predetermined amount, and thereafter maintaining the power reference level setting for a period of time based upon the occurrence of a predetermined number of times successive filter output values fall below a threshold level.

4. A method according to any preceding claim, wherein the filter weighting coefficients are adjusted on the basis of a least mean squares algorithm, which algorithm is a function of a filter leakage coefficient and the error values; the leakage coefficient and the error values being functions of the power reference level and the average power value.

5. Apparatus for attenuating noise comprising an adjustable filter (30,34) which filter has a maximum filter output value above which filter saturation occurs; a memory adapted to store adjustable filter weighting coefficients; a sensor (29) for deriving input values representative of noise to be attenuated; a filter (30) for filtering the input values to produce filter output values based upon the adjustable filter weighting coefficients; a generator (28) adapted to generate a noise cancelling waveform from the filter output values and to superimpose the noise cancelling waveform on the noise, the sensor (29) being adapted to sense residual noise after superposition of the noise cancelling waveform on the noise; processing means (29,26) adapted to develop error values representative of the residual noise; adjusting means adapted to adjust the filter weighting coefficients on the basis of the error values so as to reduce the residual noise; characterized by monitoring means adapted to monitor the filter output values to detect the occurrence of filter saturation, the adjusting means being adapted to modify the filter weighting coefficients to decrease filter output values in response to the detection of filter saturation.

**Patentansprüche**

1. Ein Verfahren zum Abschwächen von Rauschen bzw. Lärm vermittels einer Vorrichtung, die umfaßt einen einstellbaren Filter, welcher Filter einen maximalen Filterausgangswert, oberhalb von welchem Filtersättigung auftritt, und einstellbare Filterwichtungskoeffizienten aufweist; wobei das Verfahren die Schritte umfaßt, daß Eingangswerte repräsentativ für abzuschwächendes Rauschen hergeleitet werden; die Eingangswerte gefiltert werden, um Filterausgangswerte basierend auf den einstellbaren Filterwichtungskoeffizienten zu erzeugen; eine Rauschen auslöschende Wellenform aus den Filterausgangswerten erzeugt wird und die Rauschen auslöschende Wellenform auf das Rauschen überlagert wird; restliches Rauschen nach der Überlagerung der Rauschen auslöschenden Wellenform auf das Rauschen erfaßt wird, wobei die sich entwickelnden Fehlerwerte für das restliche Rauschen repräsentativ sind; die Filterwichtungskoeffizienten auf der Grundlage der Fehlerwerte eingestellt werden, um so das restliche Rauschen zu verringern; gekennzeichnet durch die Schritte, daß die Filterausgangswerte überwacht werden, um das Auftreten von Filtersättigung zu detektieren; die Filterwichtungskoeffizienten modifiziert werden, um Filterausgangswerte im Ansprechen auf die Detektion von Filtersättigung zu erniedrigen.

2. Ein Verfahren nach Anspruch 1, worin der Schritt des Überwachens der Filterausgangswerte die Schritte umfaßt, daß ein Durchschnittsleistungswert basierend auf Filterausgangswerten erhalten wird; ein Leistungsreferenzniveau repräsentativ für eine Abschätzung eines oberen Grenzwertes für den Durchschnittsleistungswert oberhalb welcher Filtersättigung auftritt, hergeleitet wird; und, wenn der Durchschnittsleistungswert das Leistungsreferenzniveau überschreitet, die Filterwichtungskoeffizienten modifiziert werden, um die Filterausgangswerte auf der Grundlage der Differenz zwischen dem Leistungsreferenzniveau und dem Durchschnittsleistungswert zu verringern.

3. Ein Verfahren nach Anspruch 2, worin der Schritt des Herleitens des Leistungsreferenzniveaus die Schritte umfaßt, daß die Filterausgangswerte überwacht werden, um zu detektieren, ob der maximale Ausgangswert des Filters erreicht oder überschritten worden ist; wenn der maximale Filterausgangswert noch nicht erreicht oder überschritten worden ist und der Durchschnittsleistungswert größer als das Leistungsreferenzniveau ist, das Leistungsreferenzniveau dem Durchschnittsleistungswert gleichgesetzt wird; und, wenn der maximale Filterausgangswert erreicht oder überschritten worden ist, das Leistungsreferenzniveau gleich dem Durchschnittsleistungswert verringert um eine vorbestimmte Größe eingestellt wird, und danach die Leistungsreferenzniveaueinstellung für eine vorbestimmte Zeitperiode basierend auf dem Auftreten einer vorbestimmten Anzahl von Malen aufrechterhalten wird, die sukzessive Filterausgangswerte unter ein Schwellenniveau fallen.

4. Ein Verfahren nach irgendeinem vorhergehenden Anspruch, worin die Filterwichtungskoeffizienten auf der Grundlage eines Algorithmus kleinster mittlerer Quadrate eingestellt werden, welcher Algorithmus eine Funktion eines Filterleckkoeffizienten und der Fehlerwerte ist; wobei der Leckkoeffizient und die Fehlerwerte Funktionen des Leistungsreferenzniveaus und des Durchschnittsleistungswertes sind.

5. Vorrichtung zum Abschwächen von Rauschen bzw. Lärm, mit einem einstellbaren Filter (30, 34), welcher Filter einen maximalen Filterausgangswert aufweist, oberhalb von welchem Filtersättigung auftritt; einem Speicher, der dazu angepaßt ist, einstellbare Filterwichtungskoeffizienten zu speichern; einem Sensor (29) zum Herleiten von Eingangswerten, die für abzuschwächendes Rauschen repräsentativ sind; einem Filter (30) zum Filtern der Eingangswerte, um Filterausgangswerte basierend auf den einstellbaren Filterwichtungskoeffizienten zu erzeugen; einem Generator (28), der dazu angepaßt ist, eine Rauschen auslöschende Wellenform aus den Filterausgangswerten zu erzeugen und die Rauschen auslöschende Wellenform auf das Rauschen zu überlagern, wobei der Sensor (29) dazu angepaßt ist, restliches Rauschen nach der Überlagerung der Rauschen auslöschenden Wellenform auf das Rauschen zu erfassen; einem verarbeitenden Mittel (29, 26), das dazu angepaßt ist, Fehlerwerte zu entwickeln, die für das Restrauschen repräsentativ sind; einem einstellenden Mittel, das dazu angepaßt ist, die Filterwichtungskoeffizienten auf der Grundlage der Fehlerwerte einzustellen, um so das restliche Rauschen zu verringern; gekennzeichnet durch ein überwachendes Mittel, das dazu angepaßt ist, die Filterausgangswerte zu überwachen, um das Auftreten von Filtersättigung zu detektieren, wobei das einstellende Mittel dazu angepaßt ist, die Filterwichtungskoeffizienten zu modifizieren, um Filterausgangswerte im Ansprechen auf die Detektion von Filtersättigung zu verringern.

## Revendications

1. Procédé pour atténuer un bruit au moyen d'un dispositif comprenant un filtre réglable, lequel filtre possède une valeur maximale en sortie du filtre au delà de laquelle se produit la saturation, et des coefficients de pondération du filtre ajustables; procédé comprenant les étapes consistant à dériver des valeurs d'entrée représentant un bruit à atténuer; filtrer les valeurs d'entrée de manière à produire des valeurs en sortie du filtre basées sur les coefficients de pondération du filtre ajustables; engendrer une forme d'onde d'annulation de bruit à partir des valeurs de sortie du filtre et pour superposer la forme d'onde d'annulation de bruit avec du bruit; capter le bruit résiduel après superposition de la forme d'onde d'annulation de bruit avec du bruit, les valeurs d'erreur se développant étant représentatives du bruit résiduel; ajuster les coefficients de pondération du filtre sur la base des valeurs d'erreur de façon à réduire le bruit résiduel; caractérisé en ce qu'il comporte les étapes consistant à surveiller les valeurs de sortie du filtre de manière à détecter l'événement de saturation du filtre; modifier en réponse à la détection de saturation du filtre, les coefficients de pondération du filtre de manière diminuer les valeurs en sortie du filtre.

2. Procédé selon la revendication 1, dans lequel l'étape de surveillance des valeurs de sortie du filtre comprend des étapes d'obtention d'une valeur de puissance moyenne basée sur des valeurs en sortie du filtre; de dérivation d'un niveau de référence de puissance représentant une estimation d'une limite supérieure de la valeur de puissance moyenne au delà de laquelle la saturation du filtre se produit; et, lorsque la valeur de la puissance moyenne dépasse la valeur de référence de puissance de modification des coefficients de pondération du filtre de façon à diminuer les valeurs de sortie du filtre sur la base de la différence entre le niveau de référence de puissance et la valeur de la puissance moyenne.

3. Procédé selon la revendication 2, dans lequel l'étape de dérivation du niveau de référence de puissance comporte les étapes de surveillance des valeurs de sortie du filtre de manière à détecter si la valeur maximum en sortie du filtre a été atteinte ou dépassée; lorsque la valeur maximum en sortie du filtre n'a été ni atteinte ni dépassée et que la valeur de puissance moyenne est plus grande que le niveau de référence de puissance, de positionnement du niveau de référence de puissance pour le rendre égal à la valeur de puissance moyenne; et, lorsque la valeur maximum en sortie du filtre a été atteint ou dépassée, de positionnement du niveau de référence de puissance pour le rendre égal à la valeur de puissance moyenne réduite d'un montant prédéterminé, et de maintient, par la suite, du réglage du niveau de référence de puissance pendant un intervalle de temps basé sur l'événement où les valeurs successives en sortie du filtre tombent un nombre de fois successives déterminé sous un niveau de seuil.

4. Procédé selon l'une quelconque des revendications précédentes dans lequel les coefficients de pondération du filtre sont ajustés sur la base d'un algorithme des moindres carrés, lequel algorithme est une fonction d'un coefficient de fuite du filtre et des valeurs d'erreur; le coefficient de fuite et les valeurs d'erreur étant des fonctions du niveau de référence de puissance et de la valeur moyenne de la puissance.

5. Dispositif pour atténuer un bruit comprenant un filtre réglable (30, 34) lequel filtre possède une valeur maximale en sortie du filtre au delà de laquelle la saturation du filtre produit; une mémoire adaptée pour stocker des coefficients de pondération du filtre ajustables; un capteur (29) pour dériver des valeurs d'entrée représentant le bruit à atténuer; un filtre (30) pour filtrer les valeurs d'entrée afin de produire des valeurs de sortie du filtre basées sur les coefficients de pondération ajustables; un générateur (28) adapté pour engendrer une forme d'onde d'annulation de bruit à partir des valeurs de sortie du filtre et pour superposer la forme d'onde d'annulation de bruit avec le bruit, le capteur (29) étant adapté pour détecter le bruit résiduel après la superposition de la forme d'onde d'annulation de bruit avec le bruit; des moyens traitement (29, 26) adaptés pour développer des valeurs d'erreur représentant le bruit résiduel; des moyens de réglage adaptés pour ajuster les coefficients de pondération du filtre sur la base des valeurs d'erreur de manière à réduire le bruit résiduel; caractérisé en ce qu'il comporte des moyens de surveillance adaptables pour surveiller les valeurs de sortie du filtre afin de détecter l'événement de saturation du filtre, les moyens de réglage étant adaptés pour modifier les coefficients de pondération du filtre afin de faire décroître les valeurs en sortie du filtre en réponse à la détection de la saturation du filtre.

FIG.1

EP 0 492 680 B1

FIG.2

FIG.3

FIG. 4a

FIG. 4b

FIG. 5

FIG. 6a

FIG. 6b